# EUROPEAN PATENT SPECIFICATION

(11) **EP 0 464 906 B1**
(45) Date of publication and mention of the grant of the patent: **15.11.1995**
(21) Application number: 91201579.9
(22) Date of filing: 20.06.1991
(51) Int. Cl.: C08J 7/04, C09D 157/08, C23C 14/20

(54) **Polyester film support with vacuum deposited bismuth**
Polyesterfilmträger mit Bismuthbedampfung in Vakuum
Support pelliculaire de polyester au bismuth déposé sous vide

(30) Priority: 03.07.1990 EP 90201777
(43) Date of publication of application: 08.01.1992
(73) Proprietor: AGFA-GEVAERT naamloze vennootschap, 2640 Mortsel (BE)
(72) Inventor: Leenders, Luc Herwig, B-2200 Herentals (BE); D'hont, Dirk Marc, B-2640 Mortsel (BE); Voet, Luciaan Frans, B-2860 St.Katelijne-Waver (BE)

(56) References cited:
- GB-A- 2 026 901
- GB-A- 2 029 267
- GB-A- 2 064 427
- GB-B- 1 127 076
- CHEMICAL ABSTRACTS, vol. 95, part 4, 27th July 1981, page 571, abstract no.33489f, Columbus, Ohio, US; & JP-B-80 47 381 (TORAY INDUSTRIES) 29-11-1980
- Ullmann's Enc. of Ind. Chem., Vol. A11, 5th Ed., VCH, Munich 1988, pp. 93,94,105,106.

## Description

### 1. Field of the invention.

The present invention relates to a polyester film support with vacuum deposited bismuth and a method for producing a polyester film support with vacuum deposited bismuth. In particular the present invention relates to an improvement of the keeping qualities and adhesion of the vacuum deposited bismuth layer.

### 2. Background of the invention.

Polyester film supports with vacuum deposited bismuth can be applied in heat-mode recording materials having "direct read after write" (DRAW) possibilities. In the common heat-mode DRAW recording materials a thin layer of relatively low melting metals such as e.g. bismuth, their alloys or dyes is present on a support. Such layers are not light-sensitive but are responsive to the thermal energy set free by absorption of a high-intensity, short duration pulse of laser light. The writing spot ablates or melts a small amount of the thermo-sensitive layer which in the heated area by surface tension contracts and shows a small cavitation or hole.

DRAW recording materials can be used as a medium for recording an imagewise modulated laser beam to produce a human readable or machine readable record.

Human readable records are e.g. micro-images that can be read on enlargement and projection. An example thereof is computer output microfilm (COM) on a transparent support. Computer output microfilm images can be read by optical enlargement in a reader on projecting light through the COM record. The micro-film image can be duplicated on a suitable recording element such as a diazo film or a silver halide emulsion material. Hard copies of the enlarged images can be obtained in a reader-printer by techniques known e.g; from the electrophotographic art.

An example of a machine readable DRAW recording material is the optical disk. To date for the production of optical disks tellurium and its alloys have been used most widely to form highly reflective thin metal films wherein heating with laser beam locally reduces reflectivity by pit formation (ref. e.g. the periodical 'Physik in unserer Zeit', 15. Jahrg. 1984/Nr. 5, 129-130 the article "Optische Datenspeicher" by Jochen Fricke). Tellurium is toxic and has poor archival properties because of its sensitivity to oxygen and humidity.

To avoid the toxicity problem other relatively low melting metals such as bismuth have been introduced in the production of a heat-mode recording layer. Other metals suited for use in DRAW heat-mode recording are given in US-P-4499178 and US-P-4388400.

However the keeping qualities of a bismuth layer towards light, humidity and heat are still poor and thus giving rise to poor archival properties. It is furthermore important that the bismuth layer shows a good adhesion to the support to avoid defects such as pinholes in the bismuth layer.

GB-A-2.026.901 discloses the use of a chlorinated polyolefin polymer adjacent to a vacuum deposited bismuth layer to improve the sensitivity of the recording layer. GB-A-2.029.267 discloses a first and second protective layer on a bismuth recording layer to void scratches. The first protective layer contains a polymer having a softening point below 70°C. JP-B-55 47381 discloses the use of a vinylidene chloride-methyl acrylate-itaconic acid copolymer as a subbing layer between a polyester film support and a vapor deposited aluminium layer. The polyester is biaxially stretched and the subbing layer is applied between the longitudinal stretching and transversal stretching.

### 3. Summary of the invention.

It is an object of the present invention to provide a polyester film support with vacuum deposited bismuth having improved keeping qualities and adhesion to the polyester film support.

It is a further object of the present invention to use said polyester film support with vacuum deposited bismuth in a direct read after write heat mode recording method.

Still further objects of the present invention will become clear from the description hereinafter.

According to the present invention a polyester film support with vacuum deposited bismuth is provided comprising on said polyester film support in the order given (i) a subbing layer containing a homopolymer or copolymer of a monomer comprising covalently bound chlorine, (ii) a vacuum deposited bismuth layer, (iii) an adhesive resin layer and (iv) a protective layer, characterised in that said adhesive layer and optionally also said subbing layer comprises an anti-oxidizing agent.

### 4. Detailed description of the invention.

It has been found that the keeping qualities of a vacuum deposited bismuth layer and the adhesion of said vacuum deposited bismuth layer to said polyester film support can be substantially improved when said polyester film support, preferably polyethylene terephthalate is coated with a subbing layer containing a homopolymer or copolymer of a monomer comprising covalently bound chloride. Thus the diminishing of the density of said vacuum deposited bismuth layer when kept at room temperature or elevated temperature in the dark as well as in daylight is substantially reduced.

Examples of said homopolymer or copolymer suitable for use according to the present invention are e.g. polyvinyl chloride, polyvinylidene chloride, a copolymer of vinylidene chloride, an acrylic ester and itaconic acid, a copolymer of vinyl chloride and vinylidene chloride, a copolymer of vinyl chloride and vinyl acetate, a copolymer of butylacrylate, vinyl acetate and vinyl chloride or vinylidene chloride, a copolymer of vinyl chloride, vinylidene chloride and itaconic acid, a copolymer of vinyl chloride, vinyl acetate and vinyl alcohol etc.. Polymers that are water dispersable are preferred since they allow aqueous coating of the subbing layer which is ecologically advantageous.

Said homopolymer or copolymer may be prepared by various polymerization methods of the constituting monomers. For example, the polymerization may be conducted in aqueous dispersion containing a catalyst and activator, e.g. , sodium persulphate and meta sodium bisulphite, and an emulsifying and/or dispersing agent. Alternatively, the homopolymers or copolymers used with the present invention may be prepared by polymerization of the monomeric components in the bulk without added diluent, or the monomers may be reacted in appropriate organic solvent reaction media. The total catalyst-activator concentration should generally be kept within a range of about 0.01% to about 2.0% by weight of the monomer charge, and preferably within a range of concentration of 0.1% to 1.0%. Improved solubility and viscosity values are obtained by conducting the polymerization in the presence of mercaptans such as ethyl mercaptan, lauryl mercaptan, tertiary dodecyl mercaptan, etc., which are effective in reducing cross-linking in the copolymer. In general, the mercaptans should be used in concentrations of 0.1% to 5.0% by weight, based on the weight of polymerizable monomers present in the charge.

The homopolymers or copolymers used according to the invention can be coated on the hydrophobic film base or support by any suitable technique. They may be applied as an organic solvent solution but are preferably applied as an aqueous dispersion. The coating solution or dispersion may also contain SiO₂ in an amount of 0.5 % to 5 % by weight.

The polyester film support is preferably biaxially stretched at an elevated temperature of e.g. 70-120°C, reducing its thickness by about 1/2 to 1/9 or more and increasing its area 2 to 9 times. The stretching may be accomplished in two stages, transversal and longitudinal in either order or simultaneously.

Said homopolymer or copolymer of a monomer containing covalently bound chlorine can be applied before or after stretching of the polyester film support. It is preferably applied between the longitudinal and transversal stretch, in a thickness of 0.1 to 5 microns.

It was furthermore found that the keeping qualities of said vacuum deposited bismuth layer to said polyester film support comprising a subbing layer containing a homopolymer or copolymer of a monomer comprising covalently bound chlorine, can further be improved by treating said polyester film support comprising a coating of said homopolymer or copolymer with a corona discharge. Said corona discharge is preferably applied under reduced pressure just before the vacuum deposition of said bismuth layer but may alternatively applied under normal pressure before the vacuum deposition of said bismuth layer.

Preferably the material according to the invention also comprises a protective layer. Said protective layer is preferably laminated to the bismuth layer using an adhesive layer between said vacuum bismuth layer and said protective layer. Said protective layer is preferably laminated to the freshly vacuum deposited bismuth layer in a vacuum chamber just before winding. In this connection there is referred to the published European patent application 0384041.

Suitable protective layers for use with the present invention are organic resins such as styrene resins, vinyl acetate resins, methacrylic acid ester resins, amide resins, cellulosic resins, halogenated polyolefins, phenolic resins, soluble polyesters etc. Preferably used are hard resins showing high scratch resistance e.g. polyester resins such as polyethylene terephthalate, polycarbonates, polyamides, styrene and (meth)acrylate polyers and copolymers.

Suitable adhesive layers are resins described in US-P-4033770, CA-P-728607 and US-P-3131106.

Examples of anti-oxidizing agents suitable for use according to the present invention are ascorbic acid, ascorbyl palmitate, gallic acid, hydroquinones and bisphenols.

The invention will now be illustrated by the following examples without being limited thereto. All parts are by weight unless otherwise specified.

### Comparative Example 1

A polyethylene terephthalate polymer having an inherent viscosity of 0.57 dl/g was extruded at 290°C, casted, cooled and subsequently longitudinally stretched at 110°C. The stretching ratio was 3.3:1. The polyethylene terephthalate film was then cooled to 50°C in a cooling station containing water kept at 16°C. After drying said film was stretched transversely with a ratio of 3.3:1 at 100°C and heat-set at a temperature of 205°C for 1.5s. The beaded edges of the heat-set film were trimmed, the margins of the film were knurled and then the film was wound.

An aqueous solution containing 12.5% of a copolymer consisting of 88 mol % of vinylidene chloride, 10 mol % of methylacrylate and 2 mol % of itaconic acid and 1.5% of SiO₂ was prepared. The pH of the solution was adjusted to pH=8.15 using NH₄OH.

The following samples were prepared.
Sample 1: On the polyethylene terephthalate film support prepared as shown above a bismuth layer was vacuum deposited so that an optical density between 2 and 2.5 was reached.
Sample 2: A polyethylene terephtalate film support prepared as shown above while transported at a rate of 10m/min. was subjected to a corona discharge of 0.05A/2.0kV under a reduced pressure of 3*10⁻³mbar. The distance between the cathode and the polyethylene terephtalate film was 9.5cm. A bismuth layer was immediately thereafter deposited so that an optical density between 2 and 2.5 was reached.
Sample 3: On a polyethylene terephtalate film support prepared as shown above with the only difference that the above aqueous solution was coated in an amount of 0.42g/m² of dry material between the longitudinal and transversal stretch, a bismuth layer was vacuum deposited so that an optical density between 2 and 2.5 was reached.
Sample 4: A polyethylene terephthtalate film support prepared as in sample 3 while transported at a rate of 10m/min. was subjected to a corona discharge of 0.05A/2.0kV under a reduced pressure of 3*10⁻³mbar. The distance between the cathode and the polyethylene terephtalate film was 9.5cm. A bismuth layer was immediately thereafter deposited so that an optical density between 2 and 2.5 was reached.

The above 4 samples were kept in the dark at room temperature. Table 1 shows the relative decrease of the density of the bismuth layer after 1 day and after 43 days.

**Table 1**

| sample | % decrease of the density | |
|---|---|---|
| | after 1 day | after 43 days |
| 1 | 5 | 12 |
| 2 | 3.7 | 11.8 |
| 3 | 5 | 9.5 |
| 4 | 4.5 | 8.2 |

Table 1 shows that said polyester film support with vacuum deposited bismuth comprising a coating of a copolymer of vinylidene chloride, an acrylic ester and itaconic acid has improved keeping qualities at room temperature in the dark. The keeping qualities are further improved when said polyester film support comprising a coating of said copolymer of vinylidene chloride, an acrylic ester and itaconic acid was subjected to a corona discharge (sample 4) before the vacuum deposition of the bismuth layer.

### Comparative Example 2

The 4 samples prepared as described in example 1 were kept in the dark at 60°C. Table 2 shows the relative decrease of the density of the bismuth layer after 2 days and after 45 days.

**Table 2**

| sample | % decrease of the density | |
|---|---|---|
| | after 2 days | after 45 days |
| 1 | 8.0 | 16.2 |
| 2 | 9.2 | 20.4 |
| 3 | 8.3 | 15.5 |
| 4 | 3.2 | 8.7 |

Table 2 shows that said polyester film support with vacuum deposited bismuth comprising a coating of a copolymer of vinylidene chloride, an acrylic ester and itaconic acid has improved keeping qualities at 60°C in the dark. The keeping qualities are further improved when said polyester film support comprising a coating of said copolymer of vinylidene chloride, an acrylic ester and itaconic acid was subjected to a corona discharge (sample 4) before the vacuum deposition of the bismuth layer.

### Comparative Example 3

The samples 1 to 4 prepared as described in example 1 were kept in the dark at 60°C and 60% relative humidity. The density of the bismuth layer after 2 days and 45 days is shown in table 3.

**Table 3**

| sample | % decrease of the density | |
|---|---|---|
| | after 2 days | after 45 days |
| 1 | 7.6 | 25.8 |
| 2 | 11.1 | 30.0 |
| 3 | 9.1 | 20.5 |
| 4 | 5.4 | 21.3 |

Table 3 shows that said polyester film support with vacuum deposited bismuth comprising a coating of a copolymer of vinylidene chloride, an acrylic ester and itaconic acid has improved keeping qualities at 60°C and 60% relative humidity.

### Comparative Example 4

Samples 5 to 8 were prepared by laminating respectively samples 1 to 4 of example 1 under a reduced pressure of 3*10⁻³mbar with a polyethyleneterephthalate film bearing an acrylate based adhesive layer.

These samples were kept in the dark at room temperature. Table 4 shows the relative decrease of the density of the bismuth layer after 2 days and after 45 days.

**Table 4**

| sample | % decrease of the density | |
|---|---|---|
| | after 2 days | after 45 days |
| 5 | 12.2 | 24.8 |
| 6 | 9.1 | 23.3 |
| 7 | 9.2 | 22.9 |
| 8 | 3.2 | 10.7 |

Table 4 shows that the keeping qualities of the bismuth layer at room temperature are substantially improved when the polyethylene terephthalate film support coated with said copolymer of vinylidene chloride, an acrylic ester and itaconic acid was subjected to a corona discharge before the vacuum depostion of the bismuth layer.

### Comparative Example 5

The samples 5 to 8 prepared as show in example 4 were kept exposed to a Xenon Xe 1500 irradiation source commercially available from Original Hanau. The energy distribution of the Xenon irradiator is similar to that of sunlight and has an intensity corresponding to 180 kLux. Thus 1 hour irradiation with a Xenon irradiator corresponds to about 20 hours of average daylight. The relative decrease of the density of trio bismuth layer after 64 hours irradiation with said Xenon irradiator is show in table 5.

**Table 5**

| sample | % decrease of the density after 64 hours |
|---|---|
| 5 | 29.5 |
| 6 | 28.2 |
| 7 | 34.7 |
| 8 | 21.0 |

Table 5 shows that the keeping qualities of the bismuth layer at room temperature in daylight are substantially improved when the polyethylene terephthalate film support coated with said copolymer of vinylidene chloride, an acrylic ester and itaconic acid was subjected to a corona discharge before the vacuum deposition of the bismuth layer.

### Comparative Example 6

The samples 5 to 8 prepared as described in example 4 were kept 60°C in the dark. Table 6 shows the relative decrease of the density of the bismuth layer after 2 days and after 45 days.

**Table 6**

| sample | % decrease of the density | |
|---|---|---|
| | after 2 days | after 45 days |
| 5 | 19.4 | 74.1 |
| 6 | 17.9 | 76.0 |
| 7 | 17.4 | 44.3 |
| 8 | 9.4 | 14.3 |

Table 6 shows that said polyester film support with vacuum deposited bismuth comprising a coating of a copolymer of vinylidene chloride, an acrylic ester and itaconic acid has improved keeping qualities at 60°C in the dark. The keeping qualities are further improved when said polyester film support comprising a coating of said copolymer of vinylidene chloride, an acrylic ester and itaconic acid was subjected to a corona discharge (sample 8) before the vacuum deposition of the bismuth layer.

### Example 7

An acrylate based adhesive was dissolved in 100ml of methylethylketon. From this solution the following two samples were prepared.

Sample 9: To a solution of said adhesive layer 0.1g of ascorbylpalmitate was added. The thus obtained solution was coated on a polyethylene terephthalate support to a dry thickness of 10 µm. The thus obtained material was laminated under a reduced pressure of 3*10⁻³mbar to sample 3 of example 1.

Sample 10 was prepared in the same way as Sample 9 with the only difference that 0.2g of ascorbyl palmitate was added to 100ml of a solution of said adhesive layer.

The relative decrease of the density of the bismuth layer after 1 day and 170 days storage at room temperature in the dark are shown in table 7.

**Table 7**

| sample | % decrease of the density | |
|---|---|---|
| | after 1 day | after 170 days |
| 9 | 2.7 | 16.5 |
| 10 | 2.5 | 15.4 |

## Claims

1. A polyester film support with vacuum deposited bismuth comprising on said polyester film support in the order given (i) a subbing layer containing a homopolymer or copolymer of a monomer comprising covalently bound chlorine, (ii) a vacuum desposited bismuth layer, (iii) an adhesive resin layer and (iv) a protective layer, characterized in that said adhesive layer and optionally also said subbing layer comprises an anti-oxidizing agent.

2. Polyester film support according to claim 1, wherein said anti-oxidizing agent is a member selected from the group consisting of ascorbic acid, ascorbyl palmitate, gallic acid, a hydroquinone and a bisphenol.

3. Polyester film support according to claim 1 or 2, wherein said copolymer is a copolymer of vinylidene chloride, an acrylic ester and itaconic acid.

4. The use as recording material of a polyester film support with vacuum deposited bismuth as defined in any of claim 1 to 3, wherein said material has direct read after write possibilities and is used in a heat mode recording method.

## Patentansprüche

1. Ein Polyesterfilmträger mit vakuumaufgedamptem Bismut, der darauf aufgebracht in der angegebenen Reihenfolge aufeinanderfolgend (i) eine Haftschicht, die ein Homopolymeres oder Copolymeres eines Monomeren mit kovalent gebundenem Chlor enthält, (ii) eine vakuumaufgedampfte Bismut-Schicht, (iii) eine Klebeharzschicht und (iv) eine Schutzschicht umfaßt, dadurch gekennzeichnet, daß die Klebstoffschicht und wahlweise ebenfalls die Haftschicht ein Oxidationsschutzmittel umfassen.

2. Polyesterfilmträger nach Anspruch 1, dadurch gekennzeichnet, daß dieses Oxidationsschutzmittel ein Element aus der Reihe Ascorbinsäure, Ascorbylpalmitat, Gallussäure, Hydrochinon und Bisphenol ist.

3. Polyesterfilmträger nach Anspruch 1 oder 2, dadurch gekennzeichnet, daß dieses Copolymere ein Vinylidenchlorid-Acrylsäureester-Itakonsäure-Copolymeres ist.

4. Der Einsatz eines irgendeinem der Ansprüche 1 bis 3 entsprechenden Polyesterfilmträgers mit vakuumaufgedamptem Bismut als Aufzeichnungsmaterial, dadurch gekennzeichnet, daß dieses Material Fähigkeiten zum direkten Lesen nach dem Einschreiben (Direct Read After Write) aufweist und nach einem thermischen Aufzeichnungsverfahren eingesetzt wird.

## Revendications

1. Un support pelliculaire de polyster au bismuth déposé sous vide comportant dessus dans l'ordre indiqué (i) une sous-couche renfermant un homopolymère ou copolymère d'un monomère comprenant du chlore lié de façon covalente, (ii) une couche de bismuth déposé sous vide, (iii) une couche de résine adhésive et (iv) une couche protectrice, caractérisé en ce que la couche d'adhésif ainsi que, le cas échéant, la sous-couche renferment un anti-oxydant.

2. Support pelliculaire de polyster suivant la revendication 1, caractérisé en ce que cet anti-oxydant est choisi parmi l'acide ascorbique, le palmitate d'ascorbyle, l'acide gallique, une hydroquinone et un bisphénol.

3. Support pelliculaire de polyster suivant la revendication 1 ou 2, caractérisé en ce que ce copolymère est un copolymère chlorure de vinylidène-ester acrylique-acide itaconique.

4. L'emploi d'un support pelliculaire de polyster au bismuth déposé sous vide conforme à l'une quelconque des revendications 1 à 3 comme matériau d'enregistrement, caractérisé en ce que ce matériau offre des possibilités de lecture directe après l'enregistrement (direct read after write) et est utilisé suivant un procédé thermique d'enregistrement.
